# DEMANDE DE BREVET EUROPEEN

(11) **EP 0 616 226 A1**
(43) Date de publication de la demande: **21.09.1994**
(21) Numéro de dépôt: 94400533.9
(22) Date de dépôt: 11.03.1994
(51) Int. Cl.: G01R 31/36

(54) **Système de contrôle de vieillissement d'une batterie et procédé de mise en oeuvre dans un tel système**

(30) Priorité: 15.03.1993 FR 9302949
(71) Demandeur: ALCATEL CONVERTERS, F-75008 Paris (FR)
(72) Inventeur: Andrieu, Xavier, F-91220 Bretigny sur Orge (FR); Rocher, Michel, F-22700 Perros-Guirec (FR); Guillaume, Philippe, F-22300 Lannion (FR); Poignant, Philippe, F-91120 Palaiseau (FR)
(74) Mandataire: Pothet, Jean Rémy Emile Ludovic

(57) **Abrégé**

L'invention concerne notamment un système de contrôle du vieillissement d'une batterie (30) constituée par une pluralité d'éléments (32) connectés en série et acceptant une décharge complète, ce système étant caractérisé en ce qu'il comporte:
- des moyens de décharge (33) aptes à décharger à la fois seulement un des éléments (32), préalablement chargé, jusqu'à une valeur de fin de décharge;
- des moyens de mesure (35) de la quantité d'électricité fournie par chaque élément (32) déchargé pendant sa décharge;
- des moyens d'exploitation (35) de la quantité d'électricité fournie par au moins un élément (32) déchargé, aptes à détecter un vieillissement excessif de la batterie (30).

Un vieillissement excessif de la batterie se traduit notamment par une capacité résiduelle inférieure à une fraction de la capacité nominale de cette batterie.

## Description

Le domaine de l'invention est celui des systèmes de contrôle du vieillissement de batteries. Il s'applique notamment au contrôle du vieillissement de batteries de secours utilisées par exemple pour l'alimentation de répéteurs optiques. On entend par contrôle de vieillissement la vérification qu'une batterie est ou non apte à répondre à un besoin, notamment à assurer une alimentation de secours.

L'invention concerne également un procédé de contrôle du vieillissement d'une telle batterie. Par batterie, on entend dans la suite de cette description un ensemble d'éléments rechargeables connectés en série.

L'emploi de batteries de secours est fréquent dans les répéteurs optiques utilisés dans les communications par fibres optiques. Ces batteries sont prévues pour assurer une alimentation d'un répéteur lorsque la tension d'alimentation principale de ce répéteur, par exemple obtenue à partir de la tension secteur, présente une défaillance (coupure momentanée de tension secteur).

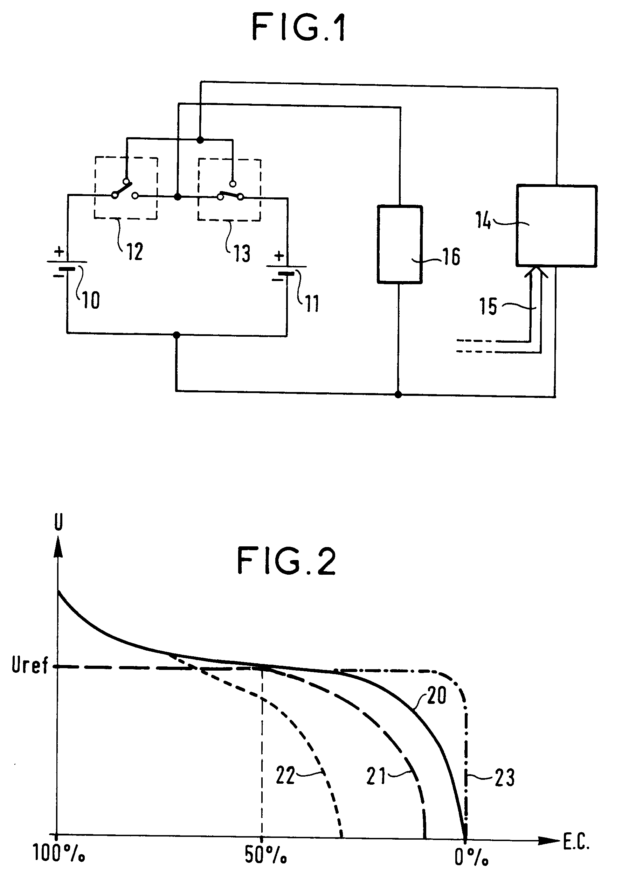

Afin d'assurer un contrôle du vieillissement d'alimentations de secours, on emploie habituellement deux batteries identiques connectées en parallèle par l'intermédiaire d'organes de commutation, conformément à la figure 1.

Deux batteries 10, 11 sont dans un circuit composé de deux branches. Chaque batterie 10, 11 coopère avec un organe de commutation de puissance 12, 13 relié d'une part à un dispositif 16 à alimenter et d'autre part à des moyens 14 de mesure de l'état de vieillissement de chaque batterie. Les batteries 10 et 11 sont prévues pour assurer une alimentation de secours du dispositif 16 dans le cas de détection d'absence ou de défaillance de l'alimentation principale de ce dispositif 16. Lorsqu'une telle défaillance se produit, les organes de commutation 12 et 13 sont actionnés de telle sorte que le dispositif 16 soit connecté aux deux batteries 10 et 11, qui sont alors en parallèle.

L'estimation de l'état de vieillissement d'une batterie est obtenu en actionnant l'organe de commutation associé, tel l'organe 12 pour la batterie 10, et en faisant débiter un courant de cette batterie dans les moyens 14. Ceux-ci comportent des moyens permettant de décharger la batterie qui y est connectée jusqu'à une tension de référence Uref correspondant à un pourcentage, par exemple 50%, de la capacité nominale d'une batterie chargée.

La figure 2 représente plusieurs caractéristiques de tensions de batteries en fonction de leur état de charge, exprimé en pour-cent.

Les caractéristiques 20 à 22 correspondent à celles d'une batterie au plomb. La caractéristique 20 est celle obtenue pour une batterie au plomb neuve, la caractéristique 21 pour cette batterie ayant déjà été utilisée depuis une certaine période et la caractéristique 22 correspond à la même batterie utilisée depuis un temps important. On constate que, si l'on fixe la tension Uref à 50% de la capacité nominale d'une batterie en parfait état de fonctionnement, une décharge d'une batterie usée du même type jusqu'à Uref ne fournit pas la même capacité (quantité d'électricité). Une mesure de l'énergie fournie par la batterie sous test jusqu'à ce que la tension à ses bornes atteigne Uref permet donc de connaître sa capacité résiduelle.

A titre indicatif, une batterie neuve de 10 Ah peut ne plus présenter qu'une capacité de 5 Ah au bout de 10 ans et il est donc effectivement nécessaire de connaître cet état de vieillissement pour assurer un bon fonctionnement du système d'alimentation de secours.

A cet effet, les moyens 14 comportent des moyens permettant de mesurer la capacité (en Ah) restituée par la batterie sous test, depuis son état de charge maximal jusqu'à la tension de référence Uref. Si la batterie sous test ne délivre plus une capacité suffisante, elle est considérée comme trop ancienne et le module 14 le signale à un opérateur qui pourra alors procéder à son remplacement. Cette opération de signalisation est habituellement réalisée par l'intermédiaire d'un bus de transmission 15 et on assure ainsi une télémaintenance pour la vérification de l'état des batteries.

Si la batterie est encore opérationnelle, c'est à dire si la capacité restituée pendant sa décharge est suffisante, les moyens 14 procèdent à sa recharge avant de tester l'autre batterie.

Le principal inconvénient de ce type de système de contrôle de vieillissement de batterie est qu'il nécessite deux batteries car l'alimentation de secours constituée par ces deux batteries doit pouvoir être sollicitée à n'importe quel moment. Dans certains cas, 75% seulement de la capacité totale est disponible, c'est à dire lorsqu'une des batteries est déchargée à 50% (fin de cycle de contrôle de son état de charge) et l'autre entièrement chargée. Augmenter le nombre de batteries n'est pas une solution acceptable car le coût du système d'alimentation de secours augmente en conséquence. Il est en effet alors nécessaire de prévoir des organes de commutation de puissance en nombre plus élevé, un par batterie, et ces organes sont coûteux lorsque le courant nécessité par le dispositif 16 est important.

Par ailleurs, les batteries utilisées dans ce genre d'alimentation secourue sont au plomb et une décharge plus importante de la batterie déjà déchargée à 50% peut mener à sa destruction. Cette décharge plus importante se produit notamment lorsqu'en fin de décharge d'une batterie, afin de tester sa capacité résiduelle, l'alimentation de secours est utilisée pour alimenter le dispositif 16.

D'autre part, les batteries au plomb ont des qualités électrochimiques bien en-deçà de celles de types de batteries plus récentes, telles que les batteries au Cadmium-Nickel. Les batteries au Cadmium-Nickel ont une caractéristique telle que 23 sur la figure 2, c'est à dire que la tension d'une telle batterie reste sensiblement constante tout au long de sa décharge. Il n'est donc pas possible de détecter le passage de la tension aux bornes de ces batteries sous la tension Uref avant qu'elle ne soit entièrement déchargée.

L'utilisation de deux batteries de secours au Cadmium-Nickel dont le vieillissement est testé conformément à la figure 1 entraîne donc une capacité globale restante de 50% seulement à la fin du test d'une des batteries. Si l'alimentation de secours est sollicitée à ce moment là, suite à une défaillance de l'alimentation principale, cette capacité résiduelle de 50% peut ne pas suffire à assurer l'alimentation secourue. Pour conserver les 75% d'autonomie obtenus avec les batteries au plomb, il est donc nécessaire d'utiliser quatre batteries de type Cadmium-Nickel, et donc d'augmenter le nombre d'organes de commutation.

La présente invention a notamment pour objectif de pallier ces inconvénients.

Plus précisément, un des objectifs de l'invention est de fournir un système de contrôle de vieillissement d'une alimentation de secours faisant appel à une batterie unique.

Un autre objectif de l'invention est de permettre l'utilisation de batteries pouvant être entièrement déchargées, telles que des batteries au Cadmium-Nickel, au Nickel-Hydrure ou au Lithium-Carbone, ce qui confère une plus grande autonomie à l'alimentation de secours.

Ces objectifs, ainsi que d'autres qui apparaîtront par la suite, sont atteints grâce à un système de contrôle du vieillissement d'une batterie constituée par une pluralité d'éléments connectés en série et acceptant d'être entièrement déchargés, ce système comportant:
- des moyens de décharge aptes à décharger à la fois seulement un des éléments, préalablement chargé, jusqu'à une valeur de fin de décharge;
- des moyens de mesure de la quantité d'électricité fournie par chaque élément déchargé pendant sa décharge;
- des moyens d'exploitation de la quantité d'électricité fournie par au moins un élément déchargé, aptes à détecter un vieillissement excessif de la batterie.

Ainsi le système de l'invention décharge au moins un des éléments d'une batterie, par exemple une batterie de secours, pour connaître l'état de vieillissement global de la batterie. Comme la décharge d'un élément peut être réalisée en circuit, c'est à dire sans déconnecter la batterie du dispositif qu'elle est destinée à alimenter, la capacité globale de la batterie reste intacte, seule la quantité d'énergie disponible étant partiellement entamée.

Le système de l'invention comporte avantageusement des moyens de recharge rechargeant chaque élément déchargé après sa décharge.

Dans une application préférentielle, la batterie est la batterie de secours d'une alimentation secourue d'un dispositif, remplaçant la source d'alimentation principale de ce dispositif lors d'une défaillance de son alimentation principale.

Les moyens d'exploitation génèrent avantageusement un signal d'alarme lorsqu'un vieillissement excessif de la batterie est détecté, ce signal d'alarme étant transmis à distance par un bus de transmission. On assure ainsi une télémaintenance de la batterie de secours.

Selon un mode de réalisation avantageux, les moyens de décharge déchargent chaque élément à courant constant et la valeur de fin de décharge correspond au temps de fin de décharge où le courant constant ne peut plus être fourni par l'élément concerné. Dans ce cas, les moyens d'exploitation comprennent des moyens de mesure du temps mis pour décharger l'élément concerné jusqu'au temps de fin de décharge, ce temps étant réprésentatif de la capacité résiduelle de l'élément testé.

Dans un autre mode de réalisation, les moyens de décharge déchargent chaque élément à courant constant et la valeur de fin de décharge correspond à une tension de référence.

Préférentiellement, les moyens de décharge sont pilotés par une tension de commande déterminant le courant constant de décharge.

Chaque élément peut coopérer avec des moyens de décharge qui lui sont dédiés ou alors ces moyens de décharge sont uniques et coopèrent avec des moyens de multiplexage adressant les éléments à décharger.

Les moyens de recharge peuvent être constitués par un générateur de courant unique servant à la génération du courant d'entretien de la batterie. Après la décharge d'un élément et le début de décharge d'un autre élément, ou du même, on attend alors un certain temps permettant de recharger l'élément déchargé.

Avantageusement, les moyens d'exploitation comparent la somme des quantités d'électricité fournies par chaque élément déchargé avec une fraction de la somme des capacités nominales des éléments déchargés et génèrent un signal d'alarme lorsque cette somme devient inférieure à la fraction.

L'invention concerne également un procédé de contrôle du vieillissement d'une batterie constituée par une pluralité d'éléments connectés en série, ce procédé consistant à:
- décharger à la fois seulement un des éléments, préalablement chargé, jusqu'à une valeur de fin de décharge prédéterminée;
- mesurer la quantité d'électricité fournie par chaque élément déchargé pendant sa décharge;
- exploiter la quantité d'électricité fournie par au moins un élément déchargé et, éventuellement, générer un message d'alarme lorsqu'un vieillissement excessif de la batterie est détecté.

Selon un premier mode de mise en oeuvre, l'exploitation des quantités d'électricité fournies par les éléments déchargés consiste à sommer les quantités d'électricité fournies par les éléments déchargés et le message d'alarme est généré lorsque cette somme est inférieure à un seuil de capacité prédéterminé. Ce mode de mise en oeuvre peut être appliqué lorsque les éléments de la batterie présentent une faible dispersion de caractéristiques.

Dans un autre mode de mise en oeuvre, l'exploitation des quantités d'électricité fournies par chaque élément déchargé consiste à mesurer la variation de la somme des quantités d'électricité fournies par les éléments déchargés, entre deux décharges successives de ces éléments, et le message d'alarme est généré lorsque cette variation devient supérieure à une valeur de quantité d'électricité prédéterminée. On détecte ainsi une perte rapide de capacité globale, signifiant que la batterie ne pourra bientôt plus répondre aux besoins.

Dans un autre mode de mise en oeuvre, l'exploitation de la quantité d'électricité fournie par un élément déchargé consiste à extrapoler la variation temporelle de la capacité de cet élément et le message d'alarme consiste en la transmission du temps qui sera nécessité par cet élément pour atteindre une capacité minimale spécifiée. On prévient ainsi un opérateur que la batterie sera bientôt inapte à répondre aux besoins.

D'autres caractéristiques et avantages de l'invention apparaîtront à la lecture de la description suivante de deux modes de réalisation préférentiels, donnés à titre illustratif et non limitatif, et des dessins annexés dans lesquels:
- la figure 1 représente une alimentation de secours d'un dispositif, associée à un système de contrôle de vieillissement de cette alimentation de secours;
- la figure 2 représente des caractéristiques de batteries au plomb et d'une batterie au Cadmium-Nickel;
- la figure 3 est un schéma synoptique d'un premier mode de réalisation d'un système de contrôle du vieillissement d'une batterie constituant par exemple l'alimentation de secours d'un dispositif;
- la figure 4 représente un mode de réalisation d'un module de décharge pouvant être associé à chaque élément de batterie;
- la figure 5 représente un schéma de principe d'un dispositif de détection de l'incapacité d'un élément sous test de fournir le courant constant qui lui est demandé;
- la figure 6 est un schéma synoptique d'un deuxième mode de réalisation d'un système de contrôle du vieillissement d'une batterie.

Les figures 1 et 2 ont été décrites précédemment en référence à l'état de la technique.

L'invention profite du fait qu'une batterie est constituée d'une pluralité d'éléments rechargeables en série, la tension aux bornes de la batterie étant égale à la somme des tensions des différents éléments. L'état de vieillissement des différents éléments, ou même d'un seul de ses éléments comme il sera vu par la suite, est représentatif de l'état de vieillissement de la batterie toute entière.

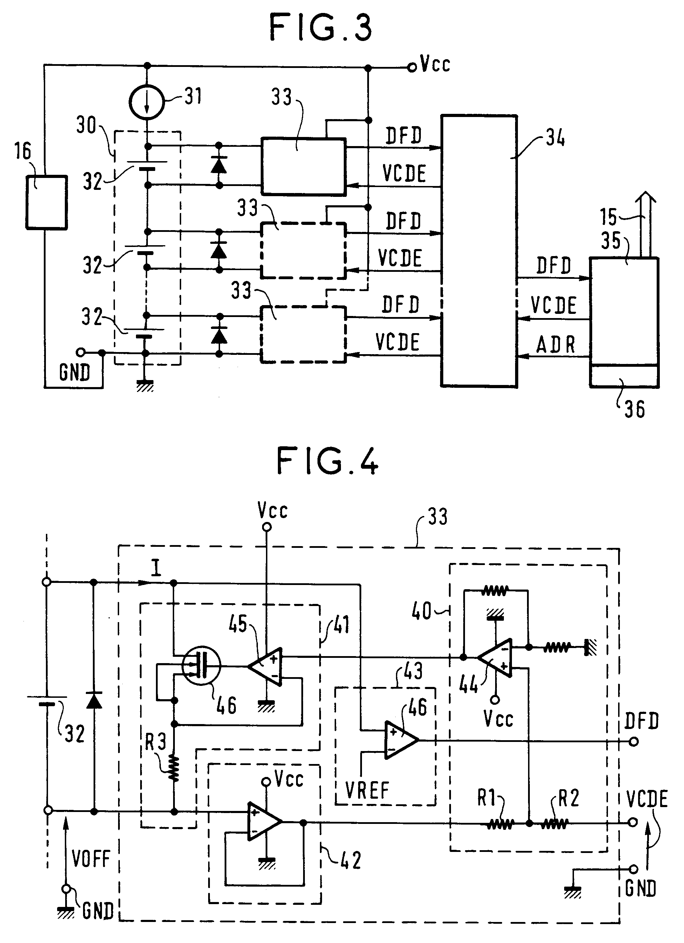

La figure 3 est un schéma synoptique d'un premier mode de réalisation d'un système de contrôle du vieillissement d'une batterie constituant l'alimentation de secours d'un dispositif.

Une batterie 30 sert d'alimentation de secours à un dispositif 16, par exemple constitué par un répéteur optique. L'alimentation principale du dispositif 16 peut être assurée par une alimentation secteur non représentée fournissant une tension continue Vcc. Le courant d'entretien de la batterie 30 est fourni par un générateur de courant 31. La batterie 30 est constituée par une pluralité d'éléments 32 reliés en série, dont seuls trois sont ici représentés. Par élément de batterie on entend aussi bien un élément unitaire (une borne positive, une borne négative et un électrolyte) ou une pluralité d'éléments (au moins deux) reliés en série.

Chaque élément 32 coopère avec un moyen de décharge 33 modulaire alimenté par la source de tension principale. Une structure possible d'un module de décharge 33 est donnée à la figure 4.

Chaque module 33 comporte un étage de sommation 40, un étage de régulation de courant 41, un étage suiveur 42 et un étage 43 de détection de fin de décharge.

L'étage de sommation 40 reçoit une tension de commande Vcde d'un multiplexeur, référencé 34 sur la figure 3, sur une borne d'une résistance R2 dont l'autre borne est reliée à l'entrée d'un amplificateur opérationnel 44 monté en amplificateur de tension. La résistance R2 est en série avec une résistance R1 recevant, par l'intermédiaire de l'étage suiveur 42, une tension d'offset Voff égale à celle existant entre la borne négative de la batterie 30 et la borne négative de l'élément 32 à tester.

La tension de sortie de l'amplificateur 44 est appliquée à l'entrée positive d'un amplificateur opérationnel 45 de l'étage de régulation de courant 41. La sortie de l'amplificateur 45 est reliée à un élément de commutation, ici constitué par un transistor MOSFET de puissance 46 à canal N. La sortie de l'amplificateur 45 est reliée à la grille du transistor 46 et la source est reliée à la borne positive de l'élément 32. Le drain est relié à une résistance shunt R3 et à l'entrée négative de l'amplificateur 45. L'autre borne de la résistance shunt R3 est reliée à la borne négative de l'élément 32.

On réalise ainsi un absorbeur de courant à courant constant, ce courant constant étant fonction de la tension Vcde. Les résistances de l'étage de sommation 40 sont calculées pour chaque module de décharge 33 de telle sorte que le courant I délivré par l'élément 32 relié à cet étage soit égal à Vcde/R3. Il est ainsi possible de conserver une tension de commande Vcde par rapport à la masse et de décharger chaque élément sous un même courant constant.

L'étage de détection de fin de décharge 43 peut comporter un comparateur 46 qui compare la tension fournie par l'élément 32 à une tension de référence Vref et indique par un signal de détection de fin de décharge DFD que cette tension est passée sous la tension de référence Vref.

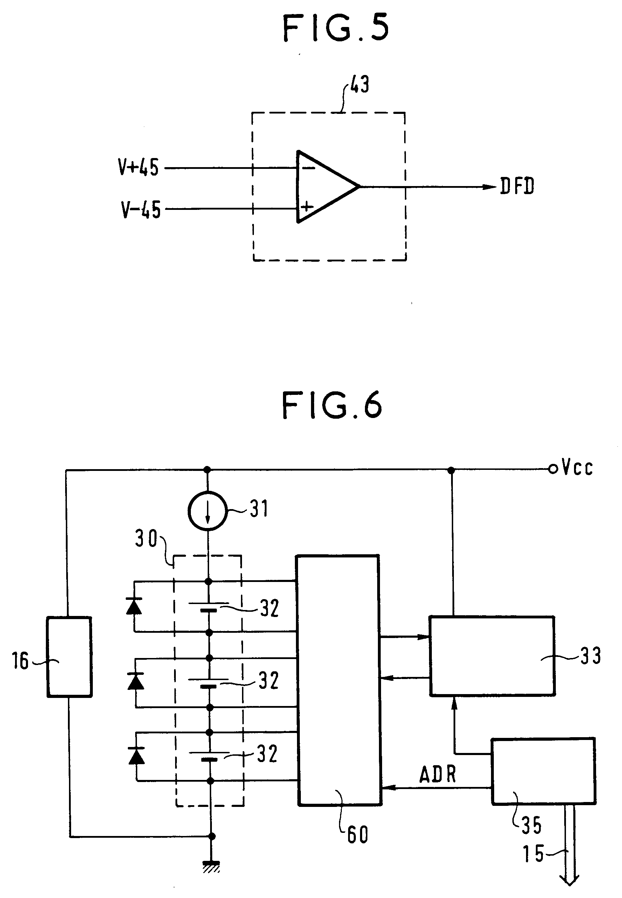

Dans un autre mode de réalisation, l'étage 43 est constitué par des moyens détectant l'incapacité de l'élément 32 sous test à délivrer le courant I qui lui est demandé. On peut à cet effet par exemple utiliser un dispositif tel que représenté à la figure 5.

Sur la figure 5 est représenté le schéma de principe d'un dispositif de détection de l'incapacité de l'élément 32 sous test de fournir le courant constant I qui lui est demandé. En début de décharge de l'élément 32, la tension V₊₄₅, appliquée à l'entrée positive de l'amplificateur opérationnel 45, est légèrement supérieure à celle V₋₄₅ de son entrée négative. Lorsque l'élément 32 ne peut plus fournir le courant I demandé, la tension V₋₄₅ chute et devient inférieure à V₊₄₅, et DFD passe à l'état logique 1.

Le signal de détection de fin de décharge DFD est appliqué à des moyens d'exploitation 35 (fig.3), par exemple constitués par un microprocesseur, comportant notamment un compteur 36 déclenché au début de la décharge de chaque élément 32. En déchargeant chaque élément à courant constant, préalablement chargé, et en mesurant le temps mis pour que soit détectée la fin de décharge (par comparaison avec une tension de référence Vref ou préférentiellement par détection de l'incapacité de fournir le courant I demandé), les moyens d'exploitation 35 peuvent estimer la quantité d'électricité, en Ah, fournie par chaque élément 32.

Selon un autre mode de réalisation, la décharge des éléments 32 est effectuée à courant variable mais pendant un temps prédéterminé. On connaît ainsi également en fin de décharge la quantité d'électricité fournie par chaque élément.

L'adressage de l'élément à tester est réalisé par l'intermédiaire d'un bus d'adresses ADR qui positionne le multiplexeur 34 pour le test d'un élément donné. De préférence, cet adressage est réalisé de manière tournante de façon à tester cycliquement et tour à tour chaque élément.

Chaque élément 32 coopère avec une diode non référencée le protégeant contre une inversion de polarité dans le cas où la batterie 30 serait sollicitée en cours de test d'un élément. La sollicitation de la batterie 30 provoque un arrêt du test en cours. Ces diodes sont par exemple de type Schottky.

Bien entendu, après décharge d'un élément, il est nécessaire de le recharger. Cette recharge est par exemple effectuée par l'intermédiaire du générateur de courant 31 qui reste constamment activé, même pendant les tests. La tension Vcde est pour cela calibrée de telle sorte qu'elle tienne compte de ce courant d'entretien. Avant de procéder à la décharge d'un nouvel élément, il est nécessaire d'attendre un temps au moins égal à la durée de charge d'entretien standard qui est fonction du courant délivré par le générateur 31.

Il est également possible d'intégrer au niveau de chaque module 33 une fonction de recharge d'élément.

Lorsque tous les éléments 32 constituant la batterie 30 ont été testés, les moyens de mesure et d'exploitation 35 peuvent calculer le pourcentage de capacité restante dans la batterie. Pour cela, les moyens 35 peuvent par exemple sommer les quantités d'énergie fournies par les éléments déchargés et comparer cette somme avec une fraction de la somme des capacités nominales des éléments déchargés, correspondant à la capacité nominale de la batterie 30. Les moyens 35 génèrent alors un signal d'alarme lorsque cette somme devient inférieure à la fraction de la capacité nominale.

A titre d'exemple, si la somme des capacités résiduelles des différents éléments, correspondant à la somme des quantités d'électricité fournies par ces éléments, devient inférieure à 80% de la capacité nominale de la batterie, un signal d'alarme est généré et transmis à un opérateur.

En vérité, la somme des capacités résiduelles est uniquement représentative de l'état de vieillissement de la batterie lorsque ces éléments sont homogènes, c'est à dire qu'ils présentent de faibles dispersions de caractéristiques au cours du temps. A ce moment là, la mesure de la capacité résiduelle d'un seul élément de la batterie est représentative de la capacité résiduelle de la batterie toute entière et le test de la batterie 30 peut être limité à celui d'un quelconque de ses éléments.

En revanche, lorsque les éléments de la batterie à tester présentent des dispersions de caractéristiques (hétérogénéité des éléments), il est possible de calculer une répartition statistique de la capacité résiduelle des éléments. Leur vieillissement peut se traduire par une diminution de la capacité résiduelle moyenne et par une augmentation de la dispersion des capacités résiduelles.

Les moyens de contrôle 35 sont préférentiellement prévus pour déclencher un signal d'alarme, transmis à distance, dans un des cas suivants, correspondants à une détection de vieillissement de la batterie 30:
- la capacité globale devient inférieure à une capacité minimale spécifiée (valable pour des éléments ayant un comportement homogène);
- observation d'une variation importante de capacité entre deux mesures successives;
- l'extrapolation de la variation temporelle de la capacité d'un élément permet de déterminer le temps qui sera nécessité pour atteindre la capacité minimale spécifiée.

Ce dernier critère d'alarme permet une maintenance prédictive de la batterie. L'alarme qui sera déclenchée permettra de prévenir un opérateur qu'il est nécessaire de remplacer la batterie.

La raison pour laquelle deux des moyens de décharge 33 sont représentés en traits discontinus est que l'état de vieillissement de la batterie 30 peut être obtenu à partir du test d'un élément 32 unique. En effet, lorsque les éléments d'une batterie sont identiques, leurs caractéristiques ne présentent généralement pas une dispersion importante, et il est possible de connaître l'état de cette batterie à partir de l'état de n'importe lequel de ses éléments.

Ainsi, selon l'invention, le système de contrôle du vieillissement d'une batterie peut uniquement comporter des moyens de décharge 33 aptes à décharger au moins un des éléments 32 préalablement chargé, jusqu'à une valeur de fin de décharge, des moyens de mesure de la quantité d'électricité fournie par chaque élément 32 déchargé pendant sa décharge et des moyens d'exploitation de la quantité d'électricité fournie par au moins un élément 32 déchargé, aptes à détecter un vieillissement excessif de la batterie 30.

On rappelle que par élément de batterie on entend aussi bien un élément unitaire (deux bornes et une électrolyte), une pluralité d'éléments (au moins deux) reliés en série.

Si l'ensemble des éléments est homogène, ce qui est généralement le cas, chaque élément est représentatif de l'état de charge de la batterie. En revanche, dans le cas d'une répartition hétérogène, la capacité résiduelle de la batterie n'est pas égale à la moyenne des capacités résiduelles des éléments.

Selon un autre mode de réalisation du système de l'invention, représenté à la figure 6, les moyens de décharge 33 sont uniques et coopèrent avec le ou les éléments 32 de la batterie 30 à tester par l'intermédiaire d'un multiplexeur 60, constituant des moyens de démultiplexage, commandé par les moyens 35 de mesure et d'exploitation de ces mesures. Les moyens 35 peuvent adresser, par la liaison ADR, n'importe quel élément 32 de la batterie 30 et le connecter aux moyens de décharge 33.

La recharge des éléments déchargés peut être assurée par le générateur de courant d'entretien 31 ou par les moyens de décharge 33. Le multiplexeur 60 est préférentiellement constitué par des relais statiques à faible résistance interne. Pour qu'un état complet de la batterie 30 puisse être réalisé, chaque élément unitaire 32 de cette batterie 30 est déchargé puis rechargé, tour à tour, et la quantité d'électricité fournie par chaque élément 32 entre dans l'estimation de l'état de la batterie 30.

L'invention concerne également un procédé de contrôle du vieillissement d'une batterie constituée par une pluralité d'éléments connectés en série, ce procédé consistant à:
- décharger à la fois seulement un des éléments, préalablement chargé, jusqu'à une valeur de fin de décharge prédéterminée;
- mesurer la quantité d'électricité fournie par chaque élément déchargé pendant sa décharge;
- exploiter la quantité d'électricité fournie par au moins un élément déchargé et, éventuellement, générer un message d'alarme lorsqu'un vieillissement excessif de la batterie est détecté.

La décharge peut s'appliquer comme précédemment indiqué à un élément unitaire seulement, ou à des éléments unitaires en série. Il est bien sûr également possible de décharger simultanément des éléments qui ne sont pas en série, c'est à dire disjoints, par exemple le premier et le dernier élément de la batterie, cette manière de procéder étant considérée comme étant un équivalent d'une décharge d'un élément unitaire ou d'éléments en série.

L'exploitation des quantités d'électricité fournies par les éléments déchargés peut consister à simplement sommer ces quantités d'électricité et un message d'alarme est alors généré lorsque cette somme est inférieure à un seuil de capacité prédéterminé. En reprenant l'exemple précédent, le seuil de capacité prédéterminé est fixé à 80% de la capacité attendue. En-deçà de cette capacité résiduelle, la batterie est considérée comme ne pouvant plus assurer l'alimentation du dispositif.

L'exploitation des quantités d'électricité fournies par chaque élément déchargé peut également consister à mesurer la variation de la somme des quantités d'électricité fournies par les éléments qui ont été déchargés, cette variation étant obtenue par deux décharges successives de ces éléments. Le message d'alarme est alors généré lorsque cette variation de quantité d'électricité devient supérieure à une valeur de quantité d'électricité prédéterminée. En effet, une chute importante de capacité résiauelle est significative d'un vieillissement des éléments testés et donc de la batterie de secours.

L'état de vieillissement de la batterie peut également être estimé en ne considérant qu'un seul élément, unitaire ou non. L'exploitation de la quantité d'électricité fournie par cet élément déchargé peut par exemple consister à extrapoler la variation temporelle de la capacité de cet élément et le message d'alarme consiste alors en la transmission du temps qui sera nécessité par cet élément pour atteindre une capacité minimale spécifiée. On réalise ainsi une prédiction de vieillissement excessif de la batterie.

Dans la présente invention, la décharge d'un élément de batterie entraîne une chute de tension aux bornes de cette batterie qui peut être insignifiante pour le dispositif alimenté. Pour rattraper éventuellement cette chute de tension, on peut prévoir un élément supplémentaire relié en série aux autres éléments de la batterie.

L'invention s'applique notamment aux batteries fournissant une tension importante, par exemple 48 volts, et donc constituées d'un nombre important d'éléments en série. La perte d'énergie engendrée par un test d'un élément est de 1/n où n est le nombre d'éléments de la batterie, contrairement à l'état de la technique où la perte d'énergie est de 25% au moins.

L'invention s'applique aux batteries qui acceptent d'être entièrement déchargées, telles que les batteries au Cadmium-Nickel ou au Lithium ou encore celles au NickelHydrure ou au Lithium-Carbone. Une décharge importante, voire complète, d'un élément d'une telle batterie est de plus bienvenue puisqu'elle reconditionne cet élément et permet d'augmenter sa durée de vie.

## Revendications

1. Système de contrôle du vieillissement d'une batterie (30) constituée par une pluralité d'éléments (32) connectés en série et acceptant d'être entièrement déchargés, caractérisé en ce qu'il comporte:
- des moyens de décharge (33) aptes à décharger à la fois seulement un desdits éléments (32), préalablement chargé, jusqu'à une valeur de fin de décharge;
- des moyens de mesure (35) de la quantité d'électricité fournie par chaque élément déchargé pendant sa décharge;
- des moyens d'exploitation (35) de la quantité d'électricité fournie par au moins un élément déchargé (32), aptes à détecter un vieillissement excessif de ladite batterie (30).

2. Système selon la revendication 1, caractérisé en ce qu'il comporte également des moyens de recharge (31, 33) rechargeant chacun desdits éléments (32) déchargés après leur décharge.

3. Système selon l'une des revendications 1 et 2, caractérisé en ce que ladite batterie (30) est la batterie de secours d'une alimentation secourue d'un dispositif (16), remplaçant ladite source d'alimentation principale de ce dispositif (16) lors d'une défaillance de son alimentation principale.

4. Système selon l'une des revendications 1 à 3, caractérisé en ce que lesdits moyens d'exploitation génèrent un signal d'alarme lorsqu'un vieillissement excessif de ladite batterie (30) est détecté, ledit signal d'alarme étant transmis à distance par un bus de transmission (15).

5. Système selon l'une des revendications 1 à 4, caractérisé en ce que lesdits moyens de décharge (33) déchargent chaque élément (32) à courant constant et en ce que ladite valeur de fin de décharge correspond au temps de fin de décharge où ledit courant constant (I) ne peut plus être fourni par l'élément (32) concerné, et en ce que lesdits moyens d'exploitation (35) comprennent des moyens de mesure du temps mis pour décharger l'élément (32) concerné jusqu'audit temps de fin de décharge.

6. Système selon l'une des revendications 1 à 4, caractérisé en ce que lesdits moyens de décharge (33) déchargent chaque élément (32) à courant constant (I) et en ce que ladite valeur de fin de décharge correspond à une tension de référence (Vref).

7. Système selon l'une des revendications 1 à 6, caractérisé en ce que lesdits moyens de décharge (33) sont pilotés par une tension de commande (Vcde) déterminant ledit courant constant (I).

8. Système selon l'une des revendications 1 à 7, caractérisé en ce que chaque élément (32) coopère avec des moyens de décharge (33) qui lui sont dédiés.

9. Système selon l'une des revendications 1 à 7, caractérisé en ce que lesdits moyens de décharge sont uniques et coopèrent avec des moyens de multiplexage (60) adressant lesdits éléments (32).

10. Système selon l'une des revendications 2 à 9, caractérisé en ce que lesdits moyens de recharge sont constitués par un générateur de courant (31) unique servant à la génération du courant d'entretien de ladite batterie (30).

11. Système selon l'une des revendications 1 à 10, caractérisé en ce que lesdits moyens d'exploitation (35) comparent la somme des quantités d'électricité fournies par chaque élément (32) déchargé avec une fraction de la somme des capacités nominales des éléments déchargés (32) et génèrent un signal d'alarme lorsque ladite somme devient inférieure à ladite fraction.

12. Système selon l'une des revendications 1 à 11, caractérisé en ce que ladite batterie est au Nickel-Cadmium, au Nickel-Hydrure ou au Lithium-Carbone.

13. Procédé de contrôle du vieillissement d'une batterie (30) constituée par une pluralité d'éléments (32) connectés en série, caractérisé en ce qu'il consiste à:
- décharger à la fois seulement un desdits éléments (32), préalablement chargé, jusqu'à une valeur de fin de décharge prédéterminée;
- mesurer la quantité d'électricité fournie par chaque élément (32) déchargé pendant sa décharge;
- exploiter la quantité d'électricité fournie par au moins un élément déchargé (32) et, éventuellement, générer un message d'alarme lorsqu'un vieillissement excessif de ladite batterie (30) est détecté.

14. Procédé selon la revendication 13, caractérisé en ce que ladite exploitation desdites quantités d'électricité fournies par lesdits éléments (32) déchargés consiste à sommer lesdites quantités d'électricité et en ce que ledit message d'alarme est généré lorsque cette somme est inférieure à un seuil de capacité prédéterminé.

15. Procédé selon la revendication 13, caractérisé en ce que ladite exploitation des quantités d'électricité fournies par chaque élément (32) déchargé consiste à mesurer la variation de la somme des quantités d'électricité fournies par lesdits éléments (32) déchargés, entre deux décharges successives de ces éléments (32), et en ce que ledit message d'alarme est généré lorsque ladite variation devient supérieure à une valeur de quantité d'électricité prédéterminée.

16. Procédé selon la revendication 13, caractérisé en ce que ladite exploitation de ladite quantité d'électricité fournie par un élément déchargé (32) consiste à extrapoler la variation temporelle de la capacité de cet élément (32) et en ce que ledit message d'alarme consiste en la transmission du temps qui sera nécessité par cet élément (32) pour atteindre une capacité minimale spécifiée.
